# NOUVEAU FASCICULE DE BREVET EUROPEEN

(11) **EP 0 359 632 B2**
(45) Date de publication et mention de la décision concernant l'opposition: **26.11.1997**
(45) Mention de la délivrance du brevet: 18.12.1991
(21) Numéro de dépôt: 89402443.9
(22) Date de dépôt: 07.09.1989
(51) Int. Cl.: G06K 19/077

(54) **Procédé d'encapsulation de circuits intégrés, notamment pour cartes à puces**
Verfahren zum Einkapseln von integrierten Schaltungen, insbesondere für Chipkarten
Integrated circuits encapsulation process, especially for chip cards

(30) Priorité: 14.09.1988 FR 8811998
(43) Date de publication de la demande: 21.03.1990
(73) Titulaire: SGS-THOMSON MICROELECTRONICS SA, 94250 Gentilly (FR)
(72) Inventeur: Steffen, Francis, F-75116 Paris (FR)
(74) Mandataire: Ballot, Paul Denis Jacques

(56) Documents cités:
- EP-A- 0 197 438
- EP-A- 0 197 847
- EP-A- 0 254 640
- EP-A- 0 277 854
- GB-A- 1 524 776
- A. EHRHARDT et al.: "Fertigungstechnik und Arbeitsmaschinen" 1972, Rowohlt Taschenbuch Verlag GmbH, Reinbeck, pages 910-913

## Description

L'invention concerne l'encapsulation de puces de circuits intégrés, notamment en vue de leur incorporation à une carte à puces.

La technique habituelle pour encapsuler des circuits intégrés destinés à être incorporés à une carte à puces est la suivante :
- la puce est reportée soit sur une grille de conducteurs métalliques soit sur une bande de matière plastique isolante portant des conducteurs imprimés ; ces conducteurs comprennent d'une part une plage de contact sur laquelle on vient souder la face arrière de la puce, et d'autre part des plages de contact sur lesquelles on vient souder des fils d'or ou d'aluminium qui sont par ailleurs soudés sur les plots de sortie de la puce; ces conducteurs constituent par ailleurs des bornes de connexion extérieures du circuit-intégré après encapsulation ;
- on recouvre la puce et ses fils d'une goutte de résine de protection contre les agressions mécaniques et chimiques ; la résine est une résine époxy ou une résine aux silicones ;
- on découpe en micromodules individuels la bande portant les puces protégées par la résine;
- on colle le micromodule dans une cavité superficielle ménagée dans une carte plate en matière plastique, de telle sorte que les conducteurs de connexion restent accessibles en surface de la carte.

La carte en matière plastique peut être réalisée par moulage par injection (la matière est alors par exemple de la résine ABS) ; elle peut aussi être réalisée par laminage de feuilles de matière plastique prédécoupées (les découpes servant notamment à réaliser la cavité pour loger le micromodule) ; dans ce cas, la matière plastique peut être du chlorure de polyvinyle.

On rencontre plusieurs problèmes dans ces techniques d'encartage ; un premier problème est le risque que la résine de protection de la puce coule entre les conducteurs lors de sa mise en place ; le débordement est gênant pour les contacts de la carte à puce; un deuxième problème est l'obligation d'assembler par collage le micromodule dans la carte, la fiabilité de ce mode de fixation n'étant pas idéale compte-tenu de la différence entre les matériaux constituant la carte et ceux constituant le micromodule ; un troisième problème est la reproductibilité des dimensions extérieures du micromodule qui doit s'ajuster dans une cavité de dimensions données (de préférence très peu profonde) dans la carte à puce.

L'invention a pour but l'amélioration de la fiabilité du montage, la reproductibilité des dimensions du micromodule, et la réduction de sa hauteur, tout en conservant un procédé de fabrication facile à mettre en oeuvre.

On connaît d'après la demande européenne publiée sous le n° 0197438 un procédé d'encapsulation d'un circuit-intégré qui comprend dans l'ordre les opérations suivantes :
- préparation d'une grille de conducteurs de connexion,
- moulage de pastilles d'une matière isolante, dans un moule délimitant une forme de micromodule de matière isolante et fixation mécanique de chaque pastille par des languettes de la grille enfilées et collées ou soudées dans des gorges de la pastille, de telle façon que
   a) les ouvertures entre les conducteurs de la grille sont bouchées par la matière isolante ;
   b) une première face de la grille est recouverte de matière isolante, à l'exception de zones de contact qui restent accessibles par des fenêtres pratiquées dans les gorges ;
   c) des murs de matière isolante définissent une cavité autour de ces zones de contact,
- on met en place une puce de circuit-intégré dans la cavité et on la relie électriquement aux zones de contact accessibles;
- on remplit la cavité d'une matière de protection.

On connaît du brevet français N° 2 360 174 un bâti conducteur autour duquel on moule classiquement de chaque côté, un support en matière isolante de manière à ce que les conducteurs du bâti fassent saillie à l'intérieur du support.

On propose selon l'invention un procédé dans lequel la matière isolante est surmoulée sur la grille. La deuxième face de la grille reste complètement dénudée. Il n'y a plus à positionner et fixer chacune des pastilles préalablement fabriquées sur chacunes des ouvertures correspondantes de la grille de conducteurs.

Dans l'invention, on propose donc un procédé d'encapsulation d'un circuit-intégré, qui comprend dans l'ordre les opérations suivantes :
- préparation d'une grille de conducteurs de connexion,
- moulage d'une matière isolante, dans un moule délimitant une forme de micromodule de matière isolante et fixation de celle-ci sur la grille de telle façon que
   a) les ouvertures entre les conducteurs de la grille sont bouchées par la matière isolante;
   b) une première face de la grille est recouverte de matière isolante, à l'exception de zones de contact qui restent accessibles;
   c) des murs de matière isolante définissent une cavité autour de ces zones de contact,
- on met en place une puce de circuit-intégré dans la cavité et on la relie électriquement aux zones de contact accessibles;
- on remplit la cavité d'une matière de protection,
caractérisé en ce que
- on applique la grille étroitement contre le fond du moule, et
- la matière isclante est surmoulée sur la grille , de façon à ce que la fixation du moulage soit simultanée au moulage et de sorte que la matière injectée ne déborde pas entre les conducteurs, sur une autre face de la grille.

On réalise ainsi un micromodule qui comprend d'une part une matière isolante (plastique) surmoulée sur la grille de conducteurs et d'autre part une matière de protection (résine) pour compléter la protection de la puce contre les agressions chimiques et mécaniques.

Pour l'incorporation à une carte, on prévoit que la matière isolante surmoulée est compatible avec la matière plastique de la carte, et on peut ainsi placer le micromodule directement dans une cavité formée dans la carte, la matière isolante surmoulée du micromodule étant directement en contact avec la matière plastique de la carte ; le montage est fait par collage ou soudure par ultrasons par exemple, ce qui était difficilement possible lorsque seule la résine époxy était en contact avec la carte à puce.

On choisira de conformer la grille de conducteurs d'une manière facilitant l'ancrage de la matière isolante de surmoulage. En particulier, les bords des conducteurs de la grille pourront être coupés en biseau en certains points de manière à définir des ouvertures entre conducteurs ayant une section trapézoïdale dans le plan perpendiculaire aux faces de la grille, cette section trapézoïdale étant évasée du côté de la face dénudée de la grille et rétrécie du côté qui recevra la matière isolante surmoulée.

Par ailleurs, on conformera la surface supérieure de la matière surmoulée (du côté qui porte la puce) d'une manière adaptée à la surface qui va la recevoir dans la carte à puce. En particulier, si l'assemblage du micromodule et de la carte est fait par soudure par ultrasons, on pourra prévoir que la surface supérieure de la matière surmoulée comprend des pics d'ancrage, des bossages, ou autres formes appropriées à la soudure par ultrasons des matériaux en présence (carte et micromodule), pour favoriser la qualité de la soudure en minimisant l'énergie à apporter.

D'autres caractéristiques et avantages de l'invention apparaîtront à la lecture de la description détaillée qui suit et qui est faite en référence au dessin annexé dans lequel la figure unique représente le micromodule fabriqué selon le procédé de l'invention.

Le micromodule réalisé par le procédé selon l'invention, et prêt à être incorporé à une carte puce CP en matière plastique, est représenté en coupe verticale.

Le micromodule comporte une grille de conducteurs 10, s'étendant dans un plan perpendiculaire au plan de la figure. Cette grille est une grille classique appelée en anglais "leadframe" ; c'est une grille plane découpée par estampage d'un ruban métallique.

La grille comporte une première face ou face avant divisée en plusieurs zones conductrices parmi lesquelles certaines ont pour fonction d'établir un contact électrique entre la grille et une puce de circuit-intégré 12 ; ainsi, la puce 12 est soudée ou collée par une colle conductrice sur une zone superficielle 14 de la face avant de la grille ; des fils de liaison 16, d'or ou d'aluminium, sont soudés entre des plots de contact de la puce et d'autres zones conductrices 18 de la face avant de la grille.

La deuxième face, ou face arrière, de la grille est dénudée en principe totalement, c'est-à-dire non recouverte de matière isolante. La face arrière de la grille restera accessible directement pour un contact électrique entre les conducteurs et des contacts d'un lecteur de cartes à puces.

Une matière isolante 20 recouvre la face avant de la grille (tout autour de la puce et de ses fils, dans une zone définissant un micromodule) sans recouvrir toutefois les zones 14 et 18 réservées à l'établissement de contacts électriques entre la puce et les conducteurs de la grille. Ces zones 14 et 18 pourront servir de zones de pression lors de l'injection de la matière 20, pour éviter des bavures sur la face arrière (flash).

Cette matière isolante 20 ne recouvre pas la face arrière de la grille ; mais, comme on peut le voir sur la figure, la matière isolante 20 bouche tous les intervalles entre les conducteurs de la grille dans toute la zone du micromodule.

Lorsque les micromodules sont fabriqués en bande continue dont la grille forme le support, la matière isolante ne recouvre pas l'intervalle entre les micromodules adjacents et elle ne remplit pas les ouvertures entre conducteurs dans cet intervalle. Cette limitation est obtenue par des barres de liaison entre modules (tie-bar), qui seront découpées avant le test électrique du module.

La matière isolante 20 forme tout autour de la puce et des fils 16 une sorte de paroi 22 qui délimite une cavité dont la hauteur au dessus de la face avant de la grille est suffisante pour loger la puce et ses fils.

La cavité est complètement fermée latéralement par la paroi 22 ; elle est fermée à sa base par la matière isolante qui recouvre la face avant de la grille et aussi par la grille elle-même à l'endroit des zones 14 et 18 non recouvertes de matière isolante. Mais la cavité est ouverte à sa partie supérieure.

La cavité délimitée par la paroi 22 est complètement ou partiellement remplie d'une matière isolante de protection 24, telle qu'une résine époxy ou une résine au silicone.

On peut encore remarquer sur la figure que des moyens d'ancrage de la matière isolante 20 sur la grille 10 sont prévus ; ces moyens comprennent d'abord des ergots 26 qui sont des parties de la grille repliées vers le haut et faisant saillie dans la résine à partir du plan horizontal dans lequel est située celle-ci ; par ailleurs un autre moyen d'ancrage consiste dans la forme biseautée des bords de certains conducteurs de la grille à l'endroit des points d'ancrage désirés : au lieu que les bords soient découpés perpendiculairement au plan de la grille, certains conducteurs sont découpés obliquement ; on peut même prévoir des oblicités opposées pour deux conducteurs adjacents. De cette manière, on réalise aux points d'ancrage tels que 28 des ouvertures entre conducteurs qui ont une section trapézoïdale, le grand coté de la section du trapèze étant celui qui est du côté de la face arrière de la grille. L'emboîtement de la résine dans une telle ouverture est inarrachable et assure donc un excellent ancrage de la matière isolante 20 sur la grille.

Enfin, on peut voir sur la figure que la surface supérieure 32 de la matière isolante 20 présente des pics 30 qui sont des vecteurs d'énergie lors d'une soudure ultrason ; on peut prévoir aussi des pics en forme de clips qui s'encastrent dans la carte CP lors de l'assemblage du module sur la carte, pour réaliser cet assemblage ou pour favoriser le positionnement correct du module par rapport à la carte.

Le procédé de fabrication du micromodule selon l'invention est le suivant : on part d'une grille métallique découpée par estampage (la ou les opérations d'estampage de la grille servant également à produire les ergots d'ancrage 26 et les bords biseautés des points d'ancrage 28).

La grille est en fait un ruban continu métallique destiné à recevoir de place en place une puce pour la constitution d'un rouleau de micromodules en bande. La bande ne sera découpée en micromodules individuels qu'après fabrication des micromodules, ou même seulement au moment de l'encartage.

La grille est en fer-nickel, ou cuivre par exemple, ou encore en nickel pur ; elle peut être recouverte d'or ou d'argent, sur la face arrière et à l'endroit des zones de soudure 14 et 18 sur la face avant.

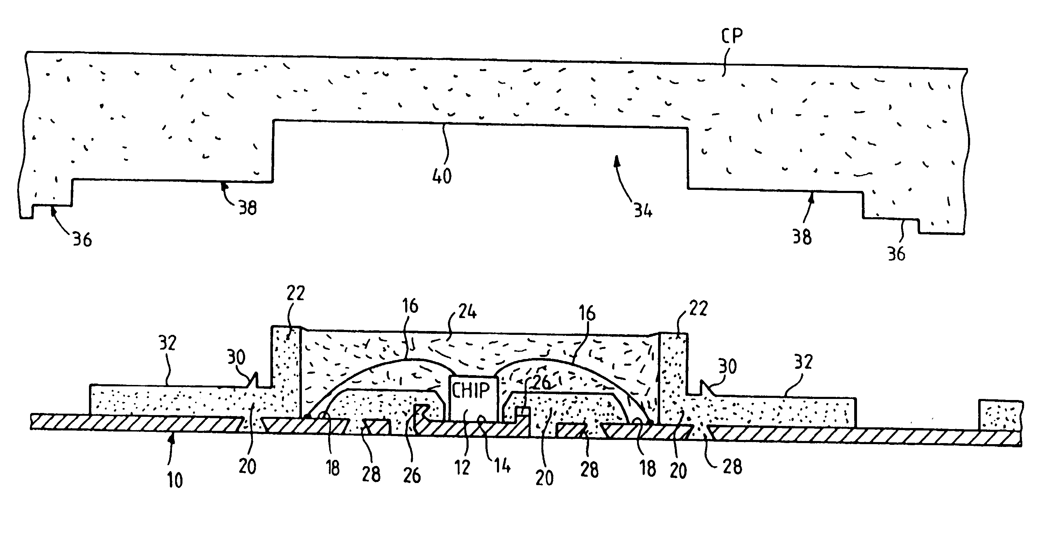

On place la grille découpée dans un moule, en vue d'une opération de surmoulage destinée à produire une structure superficielle de matière isolante 20 telle qu'elle a été décrite en référence à la figure 1.

Le moule est un moule à injection et la matière isolante injectée est une matière plastique telle que de l'ABS ou du chlorure de polyvinyle (PVC) par exemple ; le choix de la matière est dicté notamment par la compatibilité avec la matière dont est faite la carte dans laquelle le micromodule sera encarté, et par le procédé d'assemblage adopté pour le composant.

Le moule a un fond plan du coté où on va poser la face arrière de la grille. La grille sera appliquée étroitement contre ce fond de sorte que la matière injectée ne déborde pas entre les conducteurs sur la face arrière de la grille. L'autre coté du moule (coté face avant de la grille) est conformé pour définir la surface supérieure 32 du micromodule, les parois 22 de la cavité dans laquelle seront logés ultérieurement la puce et ses fils de connexion, les pics d'ancrage tels que 30, et enfin les réservations au niveau des zones 14 et 18 pour empêcher que la matière isolante ne déborde sur ces zones.

Après injection de la matière plastique 20 et refroidissement, on démoule la grille pour aboutir à une grille surmoulée par la matière 20.

On soude ou on colle une puce sur la zone 14, et on soude des fils de liaison entre les plots de contact de la puce et les zones 18.

On remplit la cavité délimitée par la paroi 22 avec une résine de protection, et le micromodule est terminé.

Les micromodules sont alors en bande continue ; cette bande se présente sous forme d'une grille en ruban qui porte de place en place un micromodule.

On décourtcircuite alors les connexions des micromodules (par estampage par exemple) pour pouvoir les tester en ruban.

A ce stade, le module sera soutenu par quelques liaisons entre la grille et la matière 20, liaisons qui seront découpées lors du montage du micromodule dans une carte plastique CP.

La carte CP est en matière plastique réalisée par moulage ou par collage de feuilles de matière plastique ; elle comporte une cavité 34 pour recevoir un micromodule ; la cavité est adaptée à la forme du micromodule: elle comprend par exemple une première cuvette 36 de très faible profondeur (égale à l'épaisseur des conducteurs de la grille) ; une deuxième cuvette 38 à l'intérieur de la première ; les surfaces supérieures 32 de la matière isolante 20 du micromodule viendront s'appliquer contre le fond de cette cuvette 38 ; et une troisième cuvette 40 plus profonde pour recevoir les parois en saillie 22 de la cavité contenant la puce 12.

Le micromodule est mis en place avec sa face avant tournée vers l'intérieur de la cavité ; la face arrière de la grille 10 affleurera sur la carte pour permettre une prise de contact électrique avec les conducteurs de la grille donc avec la puce lorsque la carte sera insérée dans un lecteur de cartes.

La fixation (collage ou soudure par ultrasons ou enclipsage) du micromodule sur la carte se fait par contact direct entre la surface 32 de la matière isolante surmoulée 20 et la matière plastique de la carte.

La précision obtenue sur les dimensions de la matière isolante surmoulée 20 est très bonne et reproductible d'un micromodule à un autre ; on ne sera donc pas gêné comme dans le passé par des problèmes d'imprécision des dimensions de la goutte de résine de protection, en hauteur comme en largeur.

La hauteur des parois 22 peut être réduite au strict minimum puisqu'elle est très bien contrôlée ; il est important pour une carte à puce que le micromodule ait une hauteur aussi réduite que possible, mais pour cela il faut un procédé très fiable et le surmoulage préalable de la grille permet cette fiabilité dimensionnelle.

On aura compris que le procédé évite que la résine de protection 24 déborde sur la face arrière de la grille.

Finalement le surmoulage de la grille avec une matière plastique permet une séparation facile des conducteurs de la grille les uns des autres à l'extérieur du micromodule lorsqu'ils doivent être "décourtcircuités". Les conducteurs sont bien maintenus en place pendant et après cette opération.

## Revendications

1. Procédé d'encapsulation d'un circuit-intégré pour une carte à circuit intégré, qui comprend dans l'ordre les opérations suivantes :
- préparation d'une grille de conducteurs de connexion (10),
- moulage d'une matière isolante (20), dans un moule délimitant une forme de micromodule de matière isolante et fixation de celle-ci sur la grille de telle façon que
a) les ouvertures entre les conducteurs de la grille sont bouchées par la matière isolante ;
b) une première face de la grille est recouverte de matière isolante, à l'exception de zones de ccntact (14, 18) qui restent accessibles ;
c) des murs (22) de matière isolante définissent une cavité autour de ces zones de contact,
- on met en place une puce de circuit-intégré (12) dans la cavité et on la relie électriquement aux zones de contact accessibles (14, 18) ;
- on remplit la cavité d'une matière de protection (24),
caractérisé en ce que
- on applique la grille étroitement contre le fond du moule, et
- la matière isolante est surmoulée sur la grille, de façon que la fixation du moulage soit simultanée au moulage, et de sorte que la matière injectée ne déborde pas entre les conducteurs sur une autre face de la grille.

2. Procédé selon la revendication 1, caractérisé en ce que on applique la grille dans le fond du moule en pressant sur des zones (14, 18) de la première face réservées à l'établissement de contact électrique entre le circuit intégré et les conducteurs de la grille, pour éviter les bavures.

3. Procédé selon l'une ries revendications 1 et 2, caractérisé en ce que le micromodule pourvu de la puce et de la matière de protection est placé dans une cavité ménagée dans une carte à puce, la première face de la grille étant tournée vers l'intérieur de la cavité de la carte.

4. Procédé selon la revendication 3, caractérisé en ce qu'un collage ou une soudure par ultrasons est effectué entre la matière isolante moulée du micromodule et la carte à l'intérieur de la cavité de la carte.

5. Procédé selon l'une des revendications 1 à 4, caractérisé en ce que des pics de matière isolante moulée sont prévus sur la surface de cette matière à des endroits où sera prévu un contact direct entre le micromodule et la carte à puce.

6. Procédé selon l'une des revendications 1 à 5, caractérisé en ce que des moyens d'ancrage sont prévus sur la grille pour assurer l'ancrage de la matière moulée sur la grille.

7. Procédé selon la revendication 6, caractérisé en ce que les moyens d'ancrage comportent des découpes biseautées de certains conducteurs de grille, de manière à former à certains endroits entre deux conducteurs de grille adjacents une ouverture de section trapézoïdale dans un plan perpendiculaire aux faces de la grille, le petit côté de la section trapézoïdale étant situé du côté de la première face de la grille.

## Patentansprüche

1. Verfahren zum Einkapseln einer integrierten Schaltung für eine Karte mit integrierter Schaltung, das in dieser Reihenfolge die folgenden Operationen umfaßt:
- Vorbereitung eines Verbindungsleitergitters (10),
- Formung eines Isoliermaterials (20) in einer die Gestalt eines aus Isoliermaterial bestehenden Mikromoduls begrenzenden Form und Befestigung des Mikromoduls auf dem Gitter, derart, daß
a) die Öffnungen zwischen den Leitern des Gitters vom Isoliermaterial versperrt werden;
b) eine erste Seite des Gitters mit Ausnahme der zugänglich bleibenden Kontaktbereiche (14, 18) mit Isoliermaterial bedeckt wird;
c) Wände (22) aus Isoliermaterial um diese Kontaktbereiche einen Hohlraum definieren,
- es wird ein integrierter Schaltungschip (12) in dem Hohlraum angebracht und elektrisch mit den zugänglichen Kontaktbereichen (14, 18) verbunden;
- der Hohlraum wird mit einem Schutzmaterial (24) gefüllt,
dadurch gekennzeichnet,
- daß das Gitter dicht an den Boden der Form angelegt wird, und
- daß das Isoliermaterial über das Gitter geformt wird, so daß die Befestigung des Formteils gleichzeitig mit der Formung erfolgt und daß das eingespritzte Material nicht zwischen den Leitern auf eine andere Seite des Gitters überläuft.

2. Verfahren gemäß Anspruch 1, dadurch gekennzeichnet, daß das Gitter dadurch an den Boden der Form angelegt wird, daß auf Bereiche (14, 18) der ersten Seite, die für das Herstellen eines elektrischen Kontakts zwischen der integrierten Schaltung und der Leitern des Gitters vorgesehen sind, Druck ausgeübt wird, um Formgrate zu verhindern.

3. Verfahren gemäß einem der Ansprüche 1 und 2, dadurch gekennzeichnet, daß der aus dem Chip und dem Schutzmaterial geschaffene Mikromodul in einem in einer Chipkarte ausgesparten Hohlraum angeordnet wird, wobei die erste Seite des Gitters zur Innenseite des Hohlraums der Karte gewandt ist.

4. Verfahren gemäß Anspruch 3, dadurch gekennzeichnet, daß zwischen dem geformten Isoliermaterial des Mikromoduls und der Karte im Inneren des Hohlraums der Karte eine Klebung oder eine Ultraschallverschweißung ausgeführt wird.

5. Verfahren gemäß einem der Ansprüche 1 bis 4, dadurch gekennzeichnet, daß auf der Oberfläche des geformten Isoliermaterials an Stellen, an denen ein direkter Kontakt zwischen dem Mikromodul und der Chipkarte geschaffen wird, aus diesem Material gebildete Spitzen vorgesehen sind.

6. Verfahren gemäß einem der Ansprüche 1 bis 5, dadurch gekennzeichnet, daß auf dem Gitter Verankerungsmittel vorgesehen sind, um die Verankerung des geformten Materials auf dem Gitter zu gewährleisten.

7. Verfahren gemäß Anspruch 6, dadurch gekennzeichnet, daß die Verankerungsmittel geschliffene Stanzränder bestimmter Leiter des Gitters umfaßt, derart, daß an bestimmten Stellen zwischen zwei benachbarten Leitern des Gitters in einer zu den Seiten des Gitters senkrechten Ebene eine Öffnung mit trapezförmigem Querschnitt gebildet wird, wobei sich die kleine Seite des trapezförmigen Querschnitts bei der ersten Seite des Gitters befindet.

## Claims

1. A method of encapsulating an integrated circuit which comprises the following operations in the following order:
- the preparation of a leadframe of connection conductors (10),
- the moulding of an insulating material (20), in a mould delimiting a micromodule configuration of insulating material and fixing the latter on the leadframe in such a manner that
(a) the openings between the conductors of the leadframe are plugged by the insulating material;
(b) a first surface of the leadframe is covered with insulating material except for the contact zones (14 and 18) which remain accessible;
(c) walls (22) of insulating material define a cavity around the said contact zones,
- an integrated circuit chip (12) is put in position in the cavity and it is connected electrically with the accessible contact zones (14, 18);
- the cavity is filled with a protective material (24),
characterized in that
- the leadframe is applied closely against the bottom of the mould, and
- the insulating material is moulded onto the leadframe in such a manner that the fixing of the moulded material is simultaneous to the moulding and so that the injected material does not overflow between the conductors on another surface of the leadframe.

2. A method according to claim 1. characterized in that the leadframe is applied to the bottom of the mould, by pressing on the zones (14, 18) of the first surface reserved for the establishment of electrical contact between the integrated circuit and the leadframe conductors, in order to avoid burs.

3. A method according to claims 1 and 2, characterized in that the micromodule provided by the chip and the protective material is positioned in a cavity made in a chip card, the first surface of the leadframe being turned towards the inside of the cavity in the card.

4. A method according to claim 3, characterized in that adhesion or ultrasonic soldering is effected between the moulded insulating material of the micromodule and the card in the interior of the cavity in the card.

5. A method according to any one of claims 1 to 4, characterized in that peaks of moulded insulating material are provided on the surface of the said material at sites where a direct contact is to be provided between the micromodule and the chip card.

6. A method according to any one of claims 1 to 5, characterized in that anchoring means are provided on the leadframe in order to ensure the anchoring of the moulded material on the leadframe.

7. A method according to claim 6, characterized in that the anchoring means comprise bevelled sections of certain conductors of the frame made in such a manner as to form, at certain sites between two adjacent conductors of the leadframe, an opening with a trapezoidal cross-section in a plane perpendicular to the surfaces of the leadframe, the minor side of the trapezoidal cross-section being located on the side of the first surface of the leadframe.
